# EUROPÄISCHE PATENTANMELDUNG

(11) **EP 2 503 431 A2**
(43) Veröffentlichungstag der Anmeldung: **26.09.2012**
(21) Anmeldenummer: 12001966.6
(22) Anmeldetag: 20.03.2012
(51) Int. Cl.: G06F 3/01, G06F 1/16

(54) **Eingabevorrichtung mit haptischer Rückmeldung**

(30) Priorität: 22.03.2011 DE 102011014763
(71) Anmelder: FM Marketing GmbH, 5162 Obertrum am See (AT)
(72) Erfinder: Maier, Ferdinand, 5162 Obertrum am See (AT); Fischer, Thomas, 83457 BayerischGmain (DE)
(74) Vertreter: von Bülow, Tam

(57) **Zusammenfassung**

Die Eingabevorrichtung mit einem Gehäuse (5) weist eine verschiebliche Deckwand (11) auf. Die verschiebliche Deckwand (11) ist mit einer Leiterbahnplatte (13) verbunden, an der ein verschiebliches Magnetteil (16), mindestens ein Sensor (L1-L4) und ein Mikroprozessor (µP) befestigt sind. Ein relativ zum Gehäuse (5) ortsfestes zweites Magnetteil (20) wirkt mit dem verschieblichen Magnetteil (16) zusammen und erzeugt bei Verschiebung der Deckwand (11) eine haptisch wahrnehmbare Kraft. Die relative Lage der Deckwand (11) zum Gehäuse (5) wird durch den mindestens einen Sensor (L1-L4) erfasst, der als Spule ausgebildet ist, die ihren Induktivitätswert in Abhängigkeit von dem erfassten Magnetfeld der beiden Magnetteile (16, 20) ändert, wobei die Spule ein frequenzbestimmendes Bauteil eines Oszillators (1) ist.

## Beschreibung

### Gebiet der Erfindung

Die Erfindung bezieht sich auf eine Eingabevorrichtung mit haptischer Rückmeldung.

### Hintergrund der Erfindung

Viele Geräte oder Gegenstände des täglichen Lebens werden heute durch Eingabevorrichtungen bedient, wie z.B. elektrische Schalter, Bedienhebel, berührungsempfindliche Bildschirme (Touchscreen), Schieberegler, Tastaturen und ähnliches, bei denen eine Rückmeldung über andere Sinnesorgane erfolgt als die Eingabe. Soll beispielsweise ein Cursor auf einem Bildschirm durch eine sog. Maus gesteuert werden, so erfolgt die Eingabe durch manuelles Bewegen der Maus während die Rückmeldung visuell durch Betrachten des Bildschirmes erfolgt. Soll die Lautstärke eines Radios verändert werden, wird bei vielen Geräten heute nur noch eine Taste gedrückt gehalten, wobei die Dauer des Drückens der Taste das Maß der Lautstärkenänderung bestimmt. Hier erfolgt die Rückmeldung akustisch.

Wünschenswert ist es, eine unmittelbare haptische Rückmeldung bei taktiler Eingabe zu erhalten, wobei die taktile Eingabe (Kraft, Weg, Richtung) unmittelbar haptisch erfahrbar ist und nicht erst durch ein eventuell zeitverzögertes System erfolgt, wie z.B. über ein nicht unmittelbar im Zusammenhang mit der Eingabe stehendes Signal.

Hierfür eignen sich magnetisch positionierte Eingabeorgane.

Die US 7,898,523 B1 zeigt eine Eingabevorrichtung mit zwei jeweils geschlossenen Gehäusen, die mit Berührungsflächen aneinander liegen und durch Magnete relativ zueinander gehalten werden. In einem der Gehäuse ist eine Leiterbahnplatte und ein optischer Sensor angeordnet, der die Berührungsfläche des anderen Sensors abtastet und ein Ausgangssignal erzeugt, das die relative Position der beiden Gehäuse zueinander anzeigt.

Die US 6,762,748 B2 zeigt eine magnetische Eingabevorrichtung mit einem Gehäuse, dessen Gehäusewand eine Öffnung hat, in der ein verschieblicher Magnet gelagert ist. Die relative Lage dieses Magneten wird durch Magnetflußsensoren erfaßt.

Die US 6,509,888 B1 zeigt eine Eingabevorrichtung mit beweglichen Magneten und Spulen als Sensor. Eine Verschiebung des Magneten induziert in der Spule eine Spannung, die ausgewertet wird.

Die DE 199 62 789 A1 zeigt eine Fensterscheiben-Betätigungsbaugruppe für ein Kraftfahrzeug mit einem Gehäuse, das eine Öffnung aufweist, durch welche hindurch ein Betätigungsorgan ragt, das mit einem Schlittenbauteil gekoppelt ist, das Kontaktfahnen trägt, die Kontakte auf einer ortsfesten Leiterplatte berühren.

Die EP 1 223 541 B1 beschreibt eine Eingabevorrichtung in Form einer Fernsteuerung, bei der zur Steuerung eines Cursors auf einem Anzeigebildschirm ein bewegliches verstellbares Teil mit einem ersten daran befestigten Magneten relativ zu einem zweiten ortsfesten Magneten bewegt und durch Hall-Sensoren das resultierende Magnetfeld gemessen wird, woraus sich die Position des beweglichen verstellbaren Teiles ermitteln läßt. Durch die Wechselwirkung der beiden Magneten wird das verstellbare Teil bei Fehlen äußerer Krafteinwirkung in eine vorbestimmte Position gebracht. Nur durch äußere Krafteinwirkung, beispielsweise durch einen Finger einer Bedienperson kann das verstellbare Teil aus dieser Ruheposition verschoben werden, wobei die Kraft, die zum Verschieben notwendig ist, von der Position der Magneten zueinander abhängt, so daß der Benutzer eine taktil oder haptisch wahrnehmbare Rückmeldung erhält.

Es kann auch ein dritter ortsfester Magnet vorgesehen sein, so daß das verstellbare Teil zwischen zwei Ruhepositionen bewegt werden kann, wobei das Verschieben aus beiden Ruhepositionen jeweils eine externe Kraft erfordert.

Weitere Beispiele von Eingabevorrichtungen mit Magneten sind aus folgenden Schriften bekannt:
DE 10117956 B4, DE 102005018275 A1,
DE 102007002189 A1, DE 202005019271 U1,
EP 0810544 A2, EP 1901005 A2,
JP 06318134 A, JP 2005004365 A,
US 5504502 A, US 7187360 B2,
US 7489296 B2, US 20C2/0054012 A1,
US 2002/0125977 A1, US 2004/0252104 A1,
US 2005/0068134 A1, US 2006/0209019 A1,
WO 03/054782 A1, WO 2006/130723 A2,
WO 2006/131520 A1 und WO 2008/016386 A2.

Die meisten der oben genannten Schriften verwenden Hall-Sensoren, die die magnetische Flußdichte messen, woraus ein Signal für die Position des beweglichen Magneten abgeleitet werden kann.

Die WO CO/70438 weist darauf hin, daß Hall-Sensoren relativ teuer sind und nur die magnetische Flußdichte messen können, so daß zum Erkennen einer Bewegungsrichtung eines Magneten mindestens zwei Hall-Sensoren erforderlich sind. Diese Schritt schlägt daher vor, als Sensoren Spulen zu verwenden. Wird ein Magnet relativ zur Spule bewegt, so wird in der Spule eine elektrische Spannung induziert, wobei ein Spannungsimpuls auch die Bewegungsrichtung detektieren läßt, da der Spannungsimpuls je nach Bewegungsrichtung mit einer ansteigenden oder absteigenden Flanke beginnt. Nachteilig an dieser Vorrichtung ist jedoch, daß nur eine Bewegung erkannt werden kann und kein statischer Zustand.

Die US 5,698,976 A beschreibt eine Eingabeeinrichtung mit einer Platte aus magnetischem Material deren Oberfläche in X- und Y-Richtung regelmäßige jedoch unterschiedliche geometrische Konfiguration in Form von Vertiefungen und Erhebungen hat. Ein Magnet ist relativ zu dieser Platte verschieblich und ein Sensor in Form einer Spule wird zusammen mit dem Magneten bewegt. Durch die unterschiedliche Geometrie der Oberfläche der Platte ändert sich der magnetische Fluß, was von der Spule detektiert wird.

In der älteren, nicht vorveröffentlichten deutschen Patentanmeldung DE 10 2010 012 247 ist eine Eingabevorrichtung beschrieben, bei der ein magnetisches Bedienteil in einer Kulissenführung längs einer Gehäusewand verschieblich ist. Die relative Lage des Magnetteiles wird durch Sensoren erfasst, die eine Spule aufweisen, die ein frequenzbestimmendes Bauelement eines Oszillators ist. Eine Änderung der Lage des Magnetteiles verändert den Induktivitätswert der Spule und damit die Frequenz des Oszillators.

In der älteren, nicht vorveröffentlichten deutschen Patentanmeldung DE 10 2010 019 596 ist eine Eingabevorrichtung beschrieben, bei der ein bewegliches Magnetteil längs einer Kreisbahn angeordnet ist. Auch dort ist das Magnetteil relativ zu der Gehäusewand verschieblich, an der es drehbar befestigt ist. Als Sensor für die Position des beweglichen Magnetteiles sind ebenfalls Spulen mit einem Oszillator vorgesehen.

Problematisch an diesen Vorrichtungen ist die Befestigung und Bedienung der beweglichen Magnetteile an der Gehäusewand. Wird das Magnetteil nur durch Magnetkräfte gehalten, so kann es abgenommen werden und verloren gehen. Ist es durch eine Kulissenführung oder einen Drehring an einer Gehäusewand befestigt, so ist die Konstruktion mechanisch aufwendig.

### Zusammenfassung der Erfindung

Aufgabe der Erfindung ist es, die Vorrichtung der eingangs genannten Art dahingehend zu verbessern, dass sie bei geringem Aufwand ein genaues elektrisches Signal für die Bewegung und/oder die Position des magnetischen beweglichen Eingabeorganes liefert und gleichzeitig eine haptisch wahrnehmbare Rückmeldung liefert.

Diese Aufgabe wird durch die im Patentanspruch 1 angegebenen Merkmale gelöst. Vorteilhafte Ausgestaltungen und Weiterbildungen der Erfindung sind den Unteransprüchen zu entnehmen.

Die Grundidee der Erfindung liegt darin, eine Gehäusewand relativ zu allen übrigen Gehäusewänden verschieblich auszugestalten. Damit ist diese Gehäusewand das Eingabeeorgan. An dieser Gehäusewand sind ein Magnetteil und eine Leiterbahnplatte mit mindestens einem Sensor befestigt. Die Leiterbahnplatte somit zusammen mit der Gehäusewand verschieblich. Zusätzlich ist an der verschieblichen Gehäusewand mindestens eine Taste angeordnet, die in Zusammenwirken mit Schaltkontakten auf der Leiterbahnplatte Schaltfunktionen auslösen kann.

### Kurze Beschreibung der Zeichnungen

Weitere Einzelheiten und Vorteile der Erfindung ergeben sich aus der nachfolgenden Beschreibung von verschiedenen Ausführungsbeispielen der Erfindung, die im Zusammenhang mit der Zeichnung ausführlicher erläutert werden. Es zeigt:
- Fig. 1.: ein Schaltbild der Einrichtung nach der Erfindung nach einem Ausführungsbeispiel der Erfindung;
- Fig. 2: einen Längsschnitt der Eingabevorrichtung nach einem ersten Ausführungsbeispiel der Erfindung;
- Fig. 3: einen Querschnitt der Eingabevorrichtung längs der Linie A-A der Fig. 2;
- Fig. 4: einen Längsschnitt der Eingabevorrichtung nach einem zweiten Ausführungsbeispiel der Erfindung.

### Detaillierte Beschreibung bevorzugter Ausführungsbeispiele der Erfindung

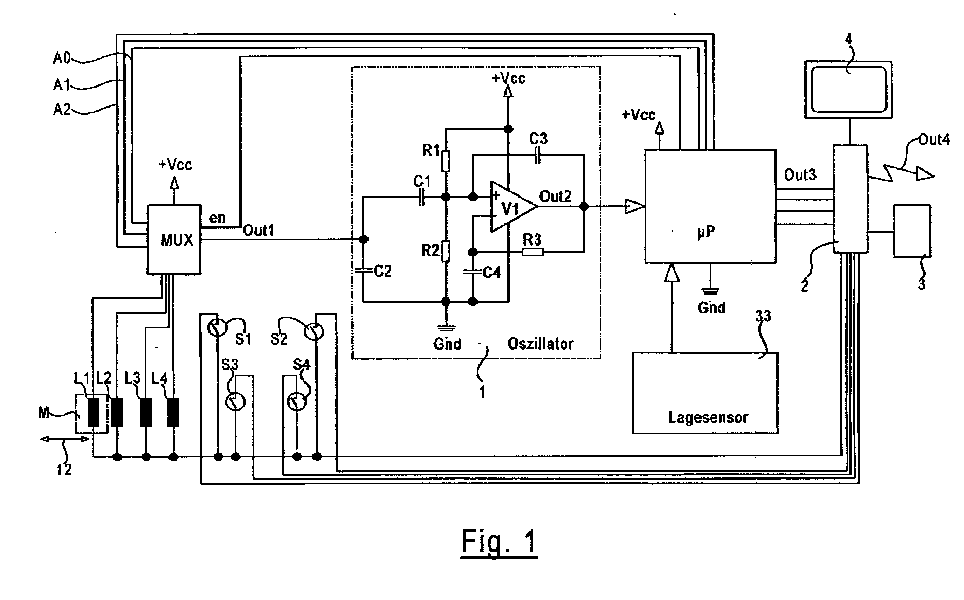

Im Schaltbild der Fig. 1 sind vier Induktivitäten L1 bis L4 zu sehen, wobei jede einzelne dargestellte Induktivität eine Spule repräsentiert, die als Sensor für die Position eines relativ zur Spule verschieblichen Magnetteiles M dient. Die Induktivitäten L1 bis L4 sind an einen Multiplexer MUX angeschlossen. Der Multiplexer MUX wird von einem Mikroprozessor µP über einen Enable-Eingang en aktiviert, wobei über Adreßleitungen A0, A1 bzw. A2 einzelne Eingänge des Multiplexers ausgewählt und auf dessen Ausgang OUT1 durchgeschaltet werden. Der Ausgang OUT1 des Multiplexer MUX wird einem Oszillator 1 zugeführt, der hier wie folgt aufgebaut ist:

Ein Operationsverstärker V1 ist mit seinem positiven Eingang (+) an einen zwischen Versorgungsspannung +Vcc und Masse (Gnd) liegenden Spannungsteiler aus Widerständen R1 und R2 angeschlossen, wobei der gemeinsame Verbindungspunkt der Widerstände R1 und R2 über einen ersten Kondensator C1 mit dem Ausgang OUT1 des Multiplexers MUX verbunden ist. Dieser Verbindungspunkt ist über einen zweiten Kondensator C2 mit Masse verbunden. Weiter ist der positive Eingang des Positionsverstärkers V1 über einen Rückkopplungskondensator C3 mit dem Ausgang des Operationsverstärkers V1 verbunden. Der negative Eingang des Operationsverstärkers ist über einen Widerstand R3 mit dem Ausgang des Operationsverstärkers V1 verbunden und über einen Kondensator C4 mit Masse.

Bei jeweils durchgeschaltetem Eingang des Multiplexers liegen somit die ausgewählte Induktivität L1 bis L4 und der Kondensator C2 in Parallelschaltung zwischen Masse und dem positiven Eingang des Operationsverstärkers V1 und bilden damit ein LC-Glied eines durch den Operationsverstärker vervollständigten Schwingkreises bzw. Oszillators 1, wobei dieses LC-Glied über den Koppelkondensator C1 mit dem positiven Eingang des Operationsverstärkers V1 verbunden ist.

Am Ausgang OUT2 des Operationsverstärkers V1 erscheint somit ein Signal, dessen Frequenz in Abhängigkeit von den jeweiligen Werten des LC-Gliedes abhängt. Der Induktivitätswert der Induktivitäten L1 bis L4 wird durch ein in die Nähe der die Induktivitäten bildenden Spulen gebrachtes Magnetteil, wie z.B. einen Magneten M, verändert, so dass im Ergebnis die Frequenz des am Ausgang OUT2 ausgegebenen Signals von der relativen Lage zwischen einem Magnetteil M und den Spulen L1 bis L4 abhängt.

Das Ausgangssignal am Ausgang OUT2 wird dem Mikroprozessor µP zugeführt, dort ausgewertet und je nach Anwendungsfall als Steuersignal an einem Ausgang OUT4 ausgegeben.

Der Ausgang OUT3 des Mikroprozessors µP kann ein serieller oder paralleler digitaler Ausgang oder auch ein analoger Ausgang sein, der je nach Einsatzzweck Treiberschaltungen 2 und/oder Aktuatoren 3 und ggf. auch einem Display 4 zugeführt wird. Die Treiberschaltung kann auch einen drahtlosen Ausgang OUT4 haben, über den ein Infrarotsignal, ein Funksignal oder ein Ultraschallsignal ausgegeben wird. Dabei enthält die Treiberschaltung 2 einen entsprechenden Sender für solche drahtlosen Signale.

Der Mikroprozessor µP kann sowohl die Frequenz als auch die zeitliche Änderung der Frequenz auswerten und somit nicht nur ein Signal ausgeben, dass die relative Lage des Magneten M zu den Einzelspulen L1 bis L4 kennzeichnet, sondern auch dessen Bewegungsgeschwindigkeit.

In Abhängigkeit von der Bewegungsgeschwindigkeit des Magnetteils M kann auch die Darstellung auf dem Display 4 verzögert oder beschleunigt abgebildet werden, was den zusätzlichen interessanten Effekt bringt, daß das subjektive Empfinden des Benutzers bezüglich der haptischen Rückmeldung der Kraft des Magneten M durch die Änderungsgeschwindigkeit der Darstellung am Display 4 verändert wird. Es wurde nämlich festgestellt, daß das haptische Empfinden durch eine zusätzliche visuelle Darstellung beeinflusst wird. Diese Funktion wird durch eine Software im Mikroprozessor realisiert.

Weiter sind in Fig. 1 vier Schalter S1, S2, S3 und S4 zu sehen, die jeweils mit der Treiberschaltung 2 so wie mit Masse Gnd verbunden sind. Anstelle der Schalter S1-S4 können auch Spulen vorgesehen sein, die entsprechend den Spulen L1 bis L4 an den Multiplexer MUX und an Masse angeschlossen sind.

Im ersten Fall wird der jeweilige Schalter S1-S4 durch eine Taste oder einen Stößel betätigt, der elektrische Schaltkontakte auf einer Leiterbahnplatte überbrückt. Im zweiten Fall kann an der Taste oder dem Stößel ein Magnet befestigt sein, der bei Niederdrücken des Stö-βels den Induktivitätswert der jeweiligen Spule verändert, was bei Abfragen der entsprechenden Spule durch den Multiplexer über den Oszillator 1 ausgewertet und dem Mikroprozessor µP zugeleitet wird.

Nach einem Ausführungsbeispiel der Erfindung ist eines der elektronischen Bauelemente ein Lagesensor 33 und/oder ein Beschleunigungssensor und/oder ein Gyroskop mit dem die Lage des Gehäuses in Bezug auf die Erdoberfläche feststellbar ist. Dieser Sensor, der im folgenden nur Lagesensor 33 bezeichnet wird, gibt an den Mikroprozessor µP der Fig. 1 ein Signal aus, das anzeigt, welche der Wände 6 bis 11 des Gehäuses 5 nach "oben" zeigt, also von der Erdoberfläche fortweist. In Abhängigkeit von diesem Signal kann der Mikroprozessor µP den Ausgangssignalen OUT 3 des Mikroprozessors µP unterschiedliche Funktionen zuweisen und optional auch den Ausgangssignalen der Schalter S1 bis S4.

Weist beispielsweise die Deckwand 11 nach oben und wird diese in Richtung des Pfeiles 12 verschoben, so kann dies als Befehl zum "Scrollen" in vertikaler Richtung interpretiert werden. Zeigt dagegen eine der Seitenwände 9 oder 10 nach oben, so kann dies "Scrollen" in horizontaler Richtung interpretiert werden.

Zeigt die Deckwand 11 nach unten und die Bodenwand 6 nach oben, so kann dies ohne Bewegung der Deckwand ein Signal erzeugen, das ein gesteuertes Gerät ausschaltet.

In analoger Weise können auch Lagen, bei denen eine der Stirnwände 7 oder 8 nach oben zeigt, mit vorgegebenen, anderen Funktionen belegt werden.

Die Geschwindigkeit des erwähnten "Scrollens" wird durch die Verschiebung der Deckwand 11 bestimmt, wobei durch die erwähnten Magnetkräfte zusätzlich eine haptisch wahrnehmbare Rückmeldung erzeugt wird.

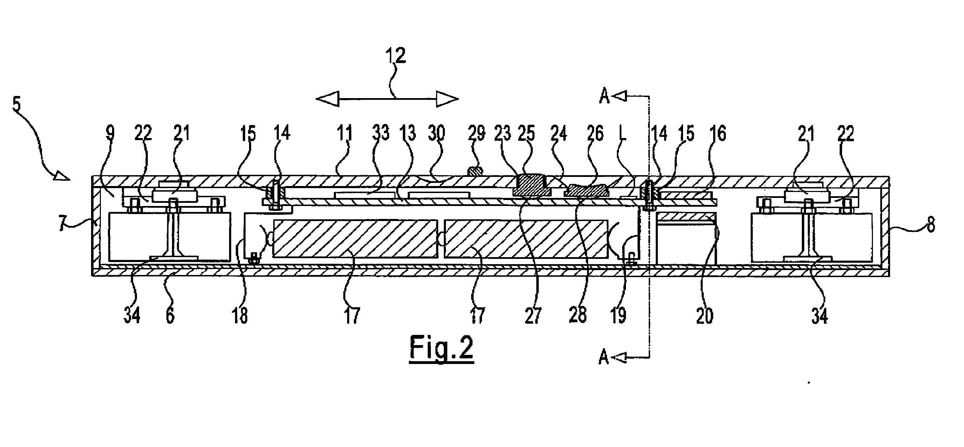

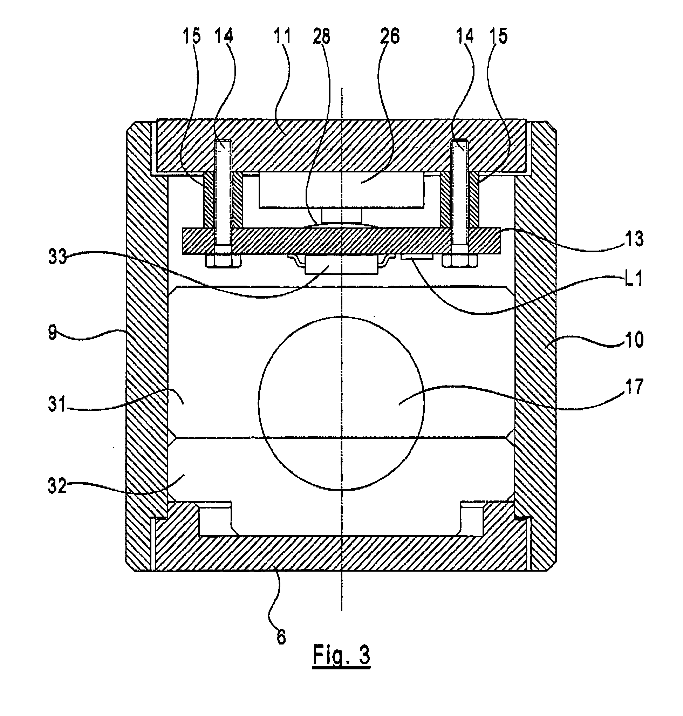

Fig. 2 zeigt einen Querschnitt einer Eingabevorrichtung nach einem Ausführungsbeispiel der Erfindung. Die Eingabevorrichtung hat ein quaderförmiges Gehäuse 5 mit sechs Wänden, nämlich einer Bodenwand 6, zwei Stirnwänden 7 und 8, zwei Seitenwänden 9 und 10 (Fig. 3) und einer Deckwand 11. Die komplette Deckwand 11 ist relativ zu den übrigen Wänden 6 bis 10 linear in Richtung des Pfeiles 12 verschieblich.

An der Deckwand 11 ist eine Leiterbahnplatte 13 befestigt, was hier durch Schrauben 14 und Distanzhülsen 15 realisiert ist. Auf der Leiterbahnplatte 13 sind alle elektrischen und elektronischen Komponenten angebracht, also insbesondere die Spulen L1 bis L4, die Schalter S1 bis S4, der Multiplexer MUX, der Oszillator 1, der Lagesensor 33 und der Mikroprozessor µP der Fig. 1. Weiter ist an der Leiterbahnplatte 13 ein Magnetteil 16 befestigt. Das Magnetteil 16 kann ein Permanentmagnet, ein Elektromagnet oder auch ein nichtmagnetisiertes Element aus ferromagnetischem Material sein.

Die Stromversorgung aller Komponenten auf der Leiterbahnplatte 13 erfolgt über Batterien 17 und flexible elektrische Leiter 18 und 19, die mit den Batterien und der Leiterbahnplatte 13 verbunden sind. Die Batterien 17 sind in einer Batterieaufnahme 31, 32 (Fig. 3) angeordnet, die ortsfest in Bezug auf die Wände 6 bis 10 des Gehäuses 5 ist.

Gegenüberliegend zu dem Magnetteil 16 auf der Leiterbahnplatte 13 ist ein zweites Magnetteil 20 angeordnet, das relativ zur Bodenwand 6 ortsfest ist. Mindestens eines der beiden Magnetteile 16, 20 ist dabei ein Magnet und insbesondere ein Permanentmagnet, während das andere Magnetteil sowohl ein Permanentmagnet als auch ein Element aus ferromagnetischem Material sein kann. Selbstverständlich können auch beide Magnetteile Permanentmagnete sein.

Die Deckwand 11 ist mit mehreren Schlitten 21 verbunden, die längs Führungsschienen 22 verschieblich sind, wobei die Führungsschienen 22 nach einem Ausführungsbeispiel der Erfindung mit der Bodenwand 6 verbunden sind.

Die Deckwand 11 hat hier zwei Durchbrüche 23 und 24, in welche Stößel 25 und 26 eingesetzt sind, die Tasten für Schaltfunktionen bilden. Im dargestellten Ausführungsbeispiel haben die Stößel 25 und 26 Schaltdome 27 und 28 bekannter Bauart, die bei Betätigung Schaltkontakte auf der Leiterbahnplatte 13 berühren und damit durchschalten.

Zum besseren Ergreifen der verschieblichen Deckwand 11 kann diese einen nach außen ragenden Vorsprung 29 oder eine nach innen weisende Griffmulde 30 aufweisen. Alternativ kann auch zumindest ein Bereich der nach au-βen weisenden Oberfläche der Deckwand 11 aufgerauht oder mit einer Riffelung versehen sein, um die "Griffigkeit" zu erhöhen.

Mindestens eines der beiden Magnetteile 16 und 20 ist so magnetisiert, dass die beiden Magnetteile eine wechselseitige Anziehungskraft aufeinander ausüben und damit die Deckwand 11 samt der Leiterbahnplatte 13 in die in Fig. 2 dargestellte "neutrale" Stellung ziehen. Wird die Deckwand 11 in Richtung des Pfeiles 12 verschoben, so wird durch die beiden Magnetteile 16 und 20 eine haptisch wahrnehmbare Gegenkraft erzeugt, deren Größe vom Verschiebeweg abhängt. Gleichzeitig wird das Magnetfeld der beiden Magnetteile 16 und 20 durch mindestens eine der Spulen L1 bis L4 auf der Leiterbahnplatte 13 sensiert, was eine Änderung des entsprechenden Induktivitätswertes bewirkt mit der Folge, dass die Ausgangsfrequenz des Oszillators 1 abhängig von der relativen Position der Deckwand 11 gegenüber dem restlichen Gehäuse 5 verändert wird.

Da sich die Leiterbahnplatte 13 und die Stößel 25 und 26 zusammen mit der Deckwand 11 bewegen, kann in jeder Verschiebeposition der Deckwand einer der Stößel 25, 26 und damit der entsprechende Schalter betätigt werden.

Fig. 3 zeigt einen Schnitt längs der Linie A-A der Fig. 2. Man erkennt hier die beiden Seitenwände 9 und 10 sowie die Bodenwand 6 und die bewegliche Deckwand 11, an welcher die Leiterbahnplatte 13 mittels Schrauben 14 und Distanzhülsen 15 befestigt ist. Weiter sieht man eine obere Batterieaufnahme 31 und eine untere Batterieaufnahme 32. Zum Auswechseln der Batterie kann die Bodenwand 6 abgenommen werden, die durch Magnetteile 34 (Fig. 2) am Gehäuse gehalten wird.

Weiter sieht man in Fig. 3 den Stößel 26 und den Schaltdom 28, der durch den Stößel 26 betätigt wird. Weiter ist eine Spule L1 angedeutet sowie der Lagesensor 33.

Da die gesamte Deckwand 11 zusammen mit der Leiterbahnplatte 13 und den Stößeln 25, 26 verschieblich ist, sind die von den Stößeln gebildeten "Tasten" in jeder Verschiebeposition der Deckwand 11 verfügbar. Durch das Verschieben der gesamten Deckwand 11 gegenüber dem restlichen Gehäuse erhält der Benutzer eine bessere haptische Wahrnehmung und zusätzlich eine visuelle Wahrnehmung im Vergleich mit dem Verschieben eines Bedienknopfes gegenüber einer Gehäusewand, wie es beim Stand der Technik bekannt ist.

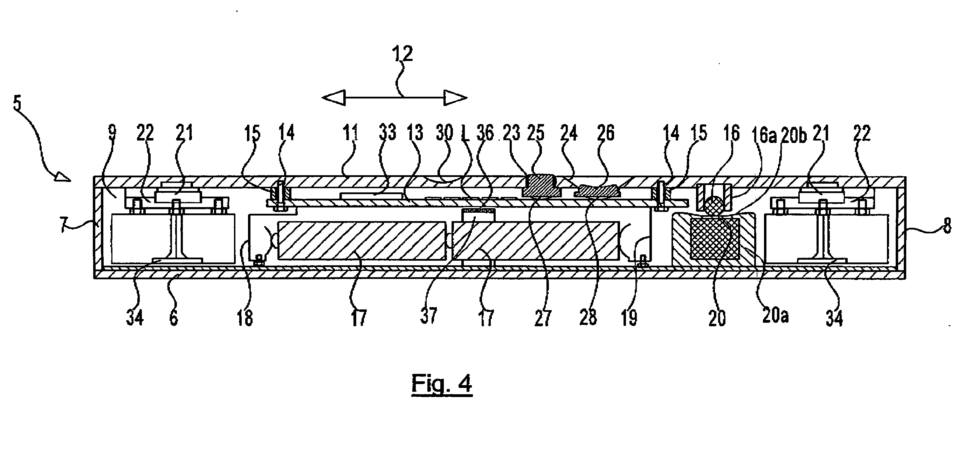

Figur 4 zeigt ein zweites Ausführungsbeispiel der Erfindung. Dieses unterscheidet sich von dem oben beschriebenen Ausführungsbeispiel im wesentlichen dadurch, dass der ortsfeste Magnet 20 quaderförmig ist und über eine Halterung 20a mit dem Gehäuseboden 6 verbunden ist. Der andere Magnet 16 ist ein zylindrischer Magnet, der in einer Hülse 16a gelagert ist und sich drehen kann. Die zum Magneten 16 weisende Oberseite 20b der Halterung 20a kann eine konkave Vertiefung 20b haben, auf der der Magnet 16 abrollen kann. Durch diese konkave Vertiefung 20b wird eine bessere Zentrierung der Neutrallage erreicht.

Die auf der Leiterbahnplatte 13 aufgebrachten Spulen L sind gegenüberliegend zu einem dritten Magnetteil 36 angeordnet, das über eine Halterung 37 ortsfest im Gehäuse gehalten ist, wobei die Halterung hier mit der Bodenwand 6 verbunden ist. Da die Spulen L, wenn sie von dem Oszillator erregt werden, ein eigenes Magnetfeld erzeugen, kann der Induktivitätswert der Spulen L auch durch ein nicht magnetisiertes Material 36, dass aber die Sensorspulen L beeinflusst, verändert werden. Somit muß das für die Sensierung der relativen Lage der Deckwand 11 in Verbindung mit den Spulen benötigte Magnetteil 36 nicht mit den Magneten 16 und 20 zusammenhängen, da die beiden Magneten 16 und 20 so weit von den Spulen L angeordnet sind, dass ihr Magnetfeld die Spulen nicht mehr beinflusst. Da andererseits die Spulen L und der Magnet 16 zusammen mit der Deckwand 11 bewegt werden, erfassen die Spulen L somit indirekt auch die relative Lage der beiden Magnetteile 16 und 20 zueinander.

Abschließend wird darauf hingewiesen, daß die Schlitten 21, mittels derer die verschiebliche Deckwand 11 gegenüber den übrigen Gehäusewänden an ortsfesten Führungsschienen 22 gelagert ist, so ausgebildet sein können, dass die Deckwand 11 zwar linear in Richtung des Pfeiles 12 gegenüber dem restlichen Gehäuse 6-10 verschoben werden kann, jedoch nicht von ihm abgenommen werden kann. Die Befestigung der Führungsschienen 22 gegenüber dem Gehäuse kann daher auch unlösbar gestaltet werden, beispielsweise indem die Magnete 34 durch Schrauben ersetzt werden, die die Führungsschienen 22 am Gehäuse fixieren. In diesem Fall muß dann in bekannter Weise ein öffenbarer Batteriefachdeckel vorgesehen werden.

## Patentansprüche

1. Eingabevorrichtung mit einem Gehäuse (5), einer Leiterbahnplatte (13), mindestens einem relativ zum Gehäuse (5) ortsfesten Magnetteil (20), mindestens einem relativ zum ortsfesten Magnetteil (20) verschieblichen Magnetteil (16), mindestens einem Sensor (L1-L4) zum Ermitteln der relativen Position der beiden Magnetteile (20, 16) zueinander und mit einem Mikroprozessor (µP), der ein Ausgangssignal (OUT3) erzeugt, das mindestens die relative Position der beiden Magnetteile (16, 20) zueinander anzeigt,
**dadurch gekennzeichnet,**
**dass** eine Deckwand (11) des Gehäuses (5) relativ zu den übrigen Wänden (6-10) des Gehäuses (5) verschieblich ist,
**dass** die verschiebliche Deckwand (11) mittels Schlitten (21) in gegenüber den übrigen Gehäusewänden (6-10) ortsfesten Führungsschienen (22) gelagert ist,
**dass** die Leiterbahnplatte (13) fest mit der verschieblichen Deckwand (13) verbunden ist, und dass das mindestens eine verschiebliche Magnetteil (16) und der mindestens eine Sensor (L1-L4) fest mit der Leiterbahnplatte (13) verbunden sind.

2. Eingabevorrichtung nach Anspruch 1, **dadurch gekennzeichnet, dass** in der Deckwand (11) mindestens eine Taste (25, 26) relativ zur Deckwand (11) verschieblich gelagert ist und dass auf der Leiterbahnplatte (13) durch die Tasten (25, 26) betätigbare Schaltorgane (27, 28) angeordnet sind.

3. Eingabevorrichtung nach Anspruch 1 oder 2, **dadurch gekennzeichnet, dass** der mindestens eine Sensor (L1-L4) eine auf die Leiterbahnplatte (13) aufgebrachte Spule ist, dass die Spule mit einem Oszillator (1) verbunden ist, dessen Ausgangssignal eine von der relativen Position der beiden Magnetteile (16, 20) zueinander abhängige Frequenz hat und dass das Ausgangssignal des Oszillators (1) mit dem Mikroprozessor (µP) verbunden ist.

4. Eingabevorrichtung nach einem der Ansprüche 1 bis 3, **dadurch gekennzeichnet, dass** ein Lagesensor (33) mit dem Mikroprozessor (µP) verbunden ist, der ein die Lage und/oder Orientierung des Gehäuses (5) im Raum anzeigendes Signal erzeugt und dass der Mikroprozessor in Abhängigkeit von diesen Signal das die relative Position der beiden Magnetteile (16, 20) zueinander anzeigende Ausgangssignal (OUT3) modifiziert.

5. Eingabevorrichtung nach einem der Ansprüche 1 bis 4, **dadurch gekennzeichnet, dass** das Ausgangssignal (OUT3) des Mikroprozessor (µP) einer Treiberschaltung (2) zugeführt wird, wobei diese Treiberschaltung (2) einen Sender zur Ausstrahlung eines drahtlosen Ausgangssignals (OUT4) aufweist.

6. Eingabevorrichtung nach einem der Ansprüche 1 bis 5, **dadurch gekennzeichnet, dass** eine nach außen weisende Oberfläche der verschieblichen Deckwand (11) einen Vorsprung (29), eine Griffmulde (30) oder eine aufgerauhte Oberfläche aufweist.

7. Eingabevorrichtung nach einem der Patentansprüche 1 bis 6, **dadurch gekennzeichnet,**
**dass** ein mit der verschieblichen Deckwand verbundenes erstes Magnetteil (16), ein zweites mit dem Gehäuse (5) verbundenes Magnetteil (20) vorgesehen sind, von denen mindestens eines ein Permanentmagnet ist und dass ein drittes Magnetteil (36) gegenüber dem mindestens einen Sensor (L1-L4) angeordnet ist, wobei das dritte Magnetteil (36) wahlweise ein Permanentmagnet oder ein unmagnetisiertes Element, das die Sensorspulen L beeinflusst.

8. Eingabevorrichtung nach Anspruch 7, **dadurch gekennzeichnet,**
**dass** das erste Magnetteil (16) ein zylindrisches Magnetteil (16) ist, das drehbar in einer Führung (16a) geführt ist und auf einer konkaven Fläche (20b) einer Halterung (20a) des zweiten Magnetteiles (20) abrollen kann.

9. Eingabevorrichtung nach Anspruch 8, **dadurch gekennzeichnet,**
**dass** die Führung (16a) eine Verschiebung des ersten Magnetteiles (16) senkrecht zur Verschieberichtung (12) der verschieblichen Deckwand (11) gestattet.
